# EUROPEAN PATENT APPLICATION

(11) **EP 4 746 041 A1**
(43) Date of publication of application: **20.05.2026**
(21) Application number: 25175928.8
(22) Date of filing: 13.05.2025
(51) Int. Cl.: H01L 23/38, H10N 10/10, H01L 23/373, H10N 10/17, H10N 10/13

(54) **POWER SEMICONDUCTOR STRUCTURE**

(30) Priority: 14.11.2024 TW 113143721
(71) Applicant: Taiwan-Asia Semiconductor Corporation, Hsinchu City 30078 (TW)
(72) Inventor: WEI, Cheng-Chang, 30078 Hsinchu City (TW); CHEN, Chuan-Wei, 30078 Hsinchu City (TW); LAI, Wen-Tsung, 30078 Hsinchu City (TW); WU, Hou-Jun, 30078 Hsinchu City (TW)
(74) Representative: Michalski Hüttermann & Partner Patentanwälte mbB

(57) **Abstract**

A power semiconductor structure is provided. The power semiconductor structure comprises a metal oxide semiconductor layer disposed on the gallium-containing oxide substrate. A thermal inner trench surrounds the gallium-containing oxide semiconductor layer and is disposed on the gallium-containing oxide substrate. A metal substrate is thermally connected to the thermal inner trench, and at least one pair of a P-type and an N-type semiconductor material are respectively connected to two ends of the metal substrate. When an external current flows into the N-type semiconductor material and flows through the metal substrate to the P-type semiconductor material, the heat energy generated by the gallium-containing oxide semiconductor layer is absorbed by the metal substrate through the thermal inner trench, and then dissipated by opposite ends of the P-type and the N-type semiconductor material opposite to the metal substrate.

## Description

### CROSS-REFERENCES TO RELATED APPLICATIONS

This application claims the benefit of priority to Taiwanese Patent Application No. 113143721 filed on November 14, 2024, which is hereby incorporated by reference in its entirety.

### BACKGROUND OF THE INVENTION

### Field of the Invention

The present invention relates to a power semiconductor structure, and in particular to a gallium-containing oxide semiconductor structure.

### Descriptions of the Related Art

Gallium oxide (Ga₂O₃) is an emerging wide-bandgap semiconductor material particularly suitable for high-power and high-frequency applications. Compared to traditional silicon (Si), silicon carbide (SiC), and gallium nitride (GaN), gallium oxide has a significantly higher breakdown electric field of approximately 8 MV/cm, which is more than ten times that of Si. Additionally, its relatively low manufacturing cost makes it highly promising for power electronic devices.

Gallium oxide has excellent application prospects in high-voltage power conversion, including transformers, switching power supplies, inverters for electric vehicles, and high-voltage transmission systems. Moreover, it performs well in high-frequency applications such as radar and microwave communication equipment. However, gallium oxide power devices face significant thermal management challenges in high-power density applications. This is primarily due to its relatively low thermal conductivity, which ranges from approximately 10 to 30 W/m·K, considerably lower than that of traditional Si (150 W/m·K), SiC (120-270 W/m·K), and GaN (130-230 W/m·K). The low thermal conductivity makes it difficult to dissipate heat efficiently from the device, thereby affecting the reliability and lifespan of power components. In light of this, the industry urgently requires an innovative power semiconductor structure to overcome the efficiency issues caused by the poor thermal conductivity of next-generation wide-bandgap semiconductor materials.

### SUMMARY OF THE INVENTION

The main objective of the present invention is to provide a power semiconductor structure that includes a gallium-containing oxide substrate and an epitaxial semiconductor material composed of a gallium-containing oxide. Since this power semiconductor structure generates a substantial amount of heat during operation, the invention incorporates an active cooling structure. By controlling an external current, this active cooling mechanism effectively dissipates heat, rapidly transferring the internally generated thermal energy to the external environment, thereby enhancing the efficiency and reliability of the power device.

To achieve the above objective, the present invention discloses a power semiconductor structure comprises a gallium-containing oxide substrate, a gallium-containing oxide semiconductor layer, a thermal inner trench, a metal substrate and at least one pair of a P-type semiconductor material and an N-type semiconductor material. The metal oxide semiconductor layer is disposed on the gallium-containing oxide substrate. The thermal inner trench surrounds the gallium-containing oxide semiconductor layer and is disposed on the gallium-containing oxide substrate. The metal substrate is thermally connected to the thermal inner trench, and the at least one pair of the P-type semiconductor materials and the N-type semiconductor materials are respectively connected to two ends of the metal substrate. When an external current flows into the N-type semiconductor material and flows through the metal substrate to the P-type semiconductor material, the heat energy generated by the gallium-containing oxide semiconductor layer is absorbed by the metal substrate through the thermal inner trench, and then dissipated by opposite ends of the P-type semiconductor material and the N-type semiconductor material opposite to the metal substrate.

In one embodiment of a power semiconductor structure of the present invention, the gallium-containing oxide substrate is a gallium oxide (Ga₂O₃) substrate.

In one embodiment of a power semiconductor structure of the present invention, the gallium oxide (Ga₂O₃) substrate is a β-gallium oxide (β-Ga₂O₃) substrate.

In one embodiment of a power semiconductor structure of the present invention, the gallium-containing oxide semiconductor layer is a gallium oxide (Ga₂O₃) semiconductor layer.

In one embodiment of a power semiconductor structure of the present invention, the power semiconductor further comprises a thermal external trench thermally connected to the opposite ends of the P-type semiconductor material and the N-type semiconductor material relative to the metal substrate.

In one embodiment of a power semiconductor structure of the present invention, the thermal inner trench and the thermal external trench comprise a thermally conductive filler therein and the thermally conductive filler is selected from one of the groups consisting of diamond, aluminum nitride, and silicon dioxide, and a combination thereof.

In one embodiment of a power semiconductor structure of the present invention, the at least one pair of the P-type semiconductor material and the N-type semiconductor material has a plurality of pairs of the P-type semiconductor material and the N-type semiconductor material, respectively connected to two ends of the metal substrate and arranged to be disposed on at least one side of the thermal inner trench.

In one embodiment of a power semiconductor structure of the present invention, the at least one pair of the P-type semiconductor material and the N-type semiconductor material has a plurality of pairs of the P-type semiconductor material and the N-type semiconductor material, respectively connected to two ends of the metal substrate and surrounding the periphery of the thermal inner trench.

In one embodiment of a power semiconductor structure of the present invention, the power semiconductor further comprises a thermal ring surrounding the periphery of the thermal external trench and thermally connected to the thermal external trench.

To achieve the above objective, the present invention discloses a power semiconductor structure which comprises a gallium oxide (Ga₂O₃) substrate, an active area, a thermal inner trench, a metal substrate and at least one pair of a P-type semiconductor material and an N-type semiconductor material. The active area is disposed on the gallium oxide substrate. The thermal inner trench surrounds the active area and is disposed on the gallium oxide substrate. The metal substrate thermally connects to the thermal inner trench. The at least one pair of the P-type semiconductor material and the N-type semiconductor material respectively connect to two ends of the metal substrate. When an external current flows into the N-type semiconductor material and flows through the metal substrate to the P-type semiconductor material, the heat energy generated by the active area is absorbed by the metal substrate through the thermal inner trench, and dissipated by opposite ends of the P-type semiconductor material and the N-type semiconductor material opposite to the metal substrate.

In one embodiment of a power semiconductor structure of the present invention, the gallium oxide substrate is a β-gallium oxide (β-Ga₂O₃) substrate.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram of a power semiconductor structure in an embodiment of the present invention;
FIG. 2 is a partially enlarged schematic diagram of an active cooling structure in an embodiment of the present invention; and
FIG. 3 is a schematic diagram of a power semiconductor structure in another embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

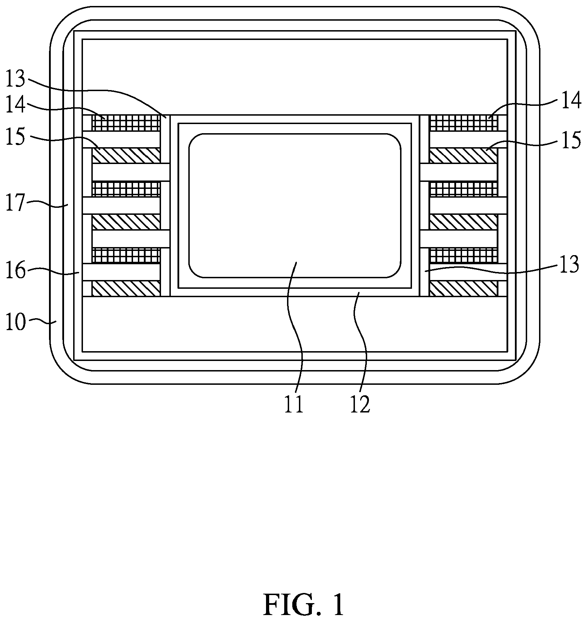

The present invention discloses a power semiconductor structure designed to address the issue of poor thermal management in power devices operating at high power densities, thereby enhancing their reliability and lifespan. Please refer to FIG. 1, which illustrates a power semiconductor structure formed on a gallium-containing oxide substrate 10. Specifically, the gallium-containing oxide substrate 10 is an ultra-wide bandgap semiconductor material, such as gallium oxide (Ga₂O₃). Gallium oxide can exist in different crystal structures, including α-Ga₂O₃, β-Ga₂O₃, γ-Ga₂O₃, δ-Ga₂O₃, and ε-Ga₂O₃. Among these, β-Ga₂O₃ is the most thermodynamically stable structure under normal temperature and pressure conditions and exhibits excellent chemical stability. Currently, most power devices developed in this technical field adopt β-Ga₂O₃. In terms of material properties, β-Ga₂O₃ is the only material that can be grown using the method of liquid-phase deposition, giving it a natural cost advantage, making it a strong competitor for next-generation power devices.

Next, an active area 11 of the power device is formed on the gallium-containing oxide substrate 10. This active area 11 includes a gallium-containing oxide semiconductor layer, which may be a gallium oxide (Ga₂O₃) semiconductor layer, with variations depending on the type of power device. The power device may be a Schottky diode, high-electron-mobility transistor (HEMT), metal-oxide-semiconductor field-effect transistor (MOSFET), static induction transistor (SIT), junction field-effect transistor (JFET), insulated-gate bipolar transistor (IGBT), or light-emitting diode (LED). During power device's operation, the active area 11 generates a significant amount of heat. However, due to the low thermal conductivity of gallium oxide, the present invention introduces a thermal inner trench 12, which surrounds the peripheral of the active area 11 and is formed on the gallium-containing oxide substrate 10. The thermal inner trench 12 is filled with a thermally conductive filler made of a high thermal conductivity material, which may be selected from a group consisting of diamond, aluminum nitride (AlN), silicon dioxide (SiO₂) and a combination thereof.

Furthermore, the present invention incorporates an active cooling structure surrounding the thermal inner trench 12. In one embodiment, the active cooling structure utilizes the Peltier effect, comprising at least one metal substrate 13 and at least one pair of an N-type semiconductor material 14 and a P-type semiconductor material 15. As shown in FIG. 1, at least one metal substrate 13 is arranged to surround the thermal inner trench 12, and the metal substrate 13 is thermally connected to the thermal inner trench 12 for allowing it to rapidly absorb most of the heat conducted from the gallium-containing oxide semiconductor layer of the active area 11 to the thermal inner trench 12. Meanwhile, the N-type semiconductor material 14 and the P-type semiconductor material 15 are paired and connected to both ends of a metal substrate 13.

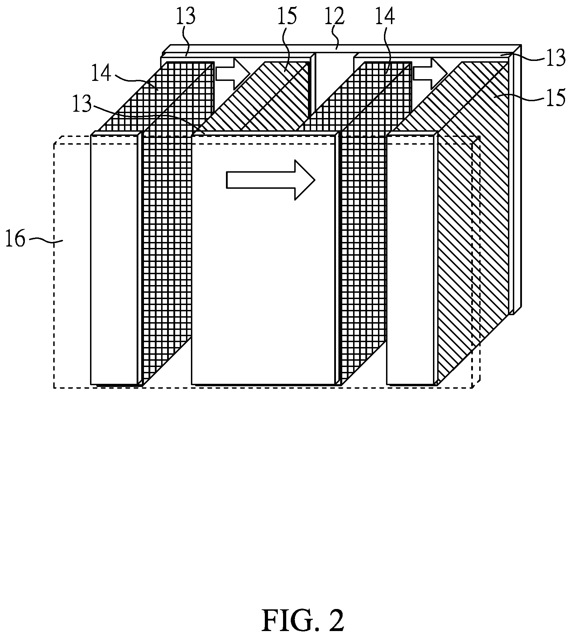

As shown in FIG. 1, multiple pairs of active cooling structures are arranged to surround the peripheral of the thermal inner trench 12. Each pair of the active cooling structures consists of one metal substrate 13 and one pair of an N-type semiconductor material 14 and a P-type semiconductor material 15, wherein the N-type semiconductor material 14 and the P-type semiconductor material 15 are connected to both ends of the metal substrate 13 adjacent to the thermal inner trench 12. Specifically, the multiple active cooling structures in FIG. 1 are disposed on both sides of the thermal inner trench 12. When the power device is in operation, the active area 11 generates a substantial amount of heat. At this moment, an external current can be conducted for causing the current to flow from the N-type semiconductor material 14 through the metal substrate 13 to the P-type semiconductor material 15. Based on the Peltier effect, heat is absorbed at the interface where the current flows from the N-type semiconductor material 14 to the P-type semiconductor material 15 for creating a cold junction. The heat generated in the gallium-containing oxide semiconductor layer of the active area 11 is first conducted to the thermal inner trench 12, then absorbed by the metal substrate 13, and subsequently transferred to the near end of either the N-type semiconductor material 14 or the P-type semiconductor material 15. Finally, the heat is dissipated at the far end of the N-type semiconductor material 14 and the P-type semiconductor material 15 relative to the metal substrate 13. It should be noted that the current between each pair of the active cooling structures is conducted through the metal substrate 13 connected to the far ends of the N-type semiconductor material 14 and the P-type semiconductor material 15 (as indicated by the arrows in FIG. 2, which represent the direction of current flow).

Please refer to FIG. 1 and FIG. 2, which further illustrate that the power semiconductor structure of the present invention includes a thermal external trench 16, surrounding the active cooling structures and formed on the gallium-containing oxide substrate 10. The thermal external trench 16 further absorbs the heat transferred by the active cooling structures. As shown in the figures, the thermal external trench 16 is thermally connected to the far ends of the N-type semiconductor material 14 and the P-type semiconductor material 15 to facilitate further heat dissipation. Similar to the thermal inner trench 12, the thermal external trench 16 is filled with a high thermal conductivity material, which may be selected from a group consisting of diamond, aluminum nitride (AlN), silicon dioxide (SiO₂), and a combination thereof. Additionally, a metal substrate 13 is further disposed between the thermal external trench 16, the N-type semiconductor material 14 and the P-type semiconductor material 15. Apart from serving as an electrical connection between multiple active cooling structures (as indicated by the arrows in FIG. 2, which represent the current flow direction), the metal substrate 13 further improves thermal conduction efficiency.

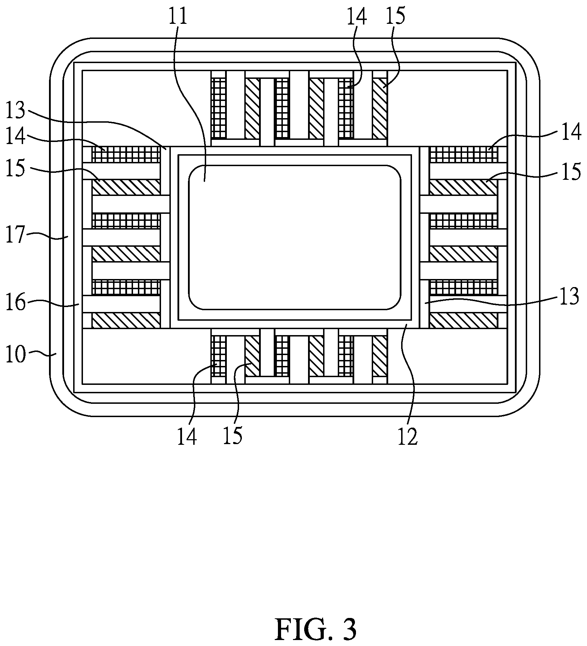

Preferably, the present invention further includes a thermal ring 17, which surrounds the peripheral of the thermal external trench 16 and is thermally connected thereto. By providing a larger heat dissipation area, the thermal ring 17 enhances the rapid heat dissipation of the power device. In practical applications, the thermal ring 17 can be combined with conventional heat dissipation structures, such as cooling fins, to achieve an optimal cooling effect. Furthermore, the active cooling structures shown in FIG. 1 are merely an exemplary embodiment and should not be considered to limit this invention. In practice, the number and layout of the active cooling structures between the thermal inner and external trenches may be adjusted according to actual requirements. As shown in FIG. 3, multiple pairs of the N-type semiconductor material 14 and the P-type semiconductor material 15 are arranged around the thermal inner trench 12, allowing the heat generated in the active area 11 to be rapidly dissipated to the thermal external trench 16 and the thermal ring 17, ultimately releasing the heat externally.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A power semiconductor structure, comprising:
a gallium-containing oxide substrate;
a gallium-containing oxide semiconductor layer, disposed on the gallium-containing oxide substrate;
a thermal inner trench, surrounding the gallium-containing oxide semiconductor layer and disposed on the gallium-containing oxide substrate;
a metal substrate, thermally connected to the thermal inner trench; and
at least one pair of a P-type semiconductor material and an N-type semiconductor material respectively connected to two ends of the metal substrate,
wherein when an external current flows into the N-type semiconductor material and flows through the metal substrate to the P-type semiconductor material, the heat energy generated by the gallium-containing oxide semiconductor layer is absorbed by the metal substrate through the thermal inner trench, and dissipated by opposite ends of the P-type semiconductor material and the N-type semiconductor material opposite to the metal substrate.

2. The power semiconductor structure of claim 1, wherein the gallium-containing oxide substrate is a gallium oxide (Ga₂O₃) substrate.

3. The power semiconductor structure of claim 2, wherein the gallium oxide (Ga₂O₃) substrate is a β-gallium oxide (β-Ga₂O₃) substrate.

4. The power semiconductor structure of any of the previous claims, wherein the gallium-containing oxide semiconductor layer is a gallium oxide (Ga₂O₃) semiconductor layer.

5. The power semiconductor structure of any of the previous claims, further comprising a thermal external trench thermally connected to the opposite ends of the P-type semiconductor material and the N-type semiconductor material relative to the metal substrate.

6. The power semiconductor structure of claim 5, wherein the thermal inner trench and the thermal external trench comprise a thermally conductive filler therein and the thermally conductive filler is selected from one of the groups consisting of diamond, aluminum nitride, and silicon dioxide, and a combination thereof.

7. The power semiconductor structure of any of the previous claims, wherein the at least one pair of the P-type semiconductor material and the N-type semiconductor material has a plurality of pairs of the P-type semiconductor material and the N-type semiconductor material, respectively connected to two ends of the metal substrate and arranged to be disposed on at least one side of the thermal inner trench.

8. The power semiconductor structure of any of the previous claims, wherein the at least one pair of the P-type semiconductor material and the N-type semiconductor material has a plurality of pairs of the P-type semiconductor material and the N-type semiconductor material, respectively connected to two ends of the metal substrate and surrounding the periphery of the thermal inner trench.

9. The power semiconductor structure of claim 5, further comprising a thermal ring surrounding the periphery of the thermal external trench and thermally connected to the thermal external trench.

10. A power semiconductor structure, comprising:
a gallium oxide (Ga₂O₃) substrate;
an active area, disposed on the gallium oxide substrate;
a thermal inner trench, surrounding the active area and disposed on the gallium oxide substrate;
a metal substrate, thermally connected to the thermal inner trench; and
at least one pair of a P-type semiconductor material and an N-type semiconductor material respectively connected to two ends of the metal substrate,
wherein when an external current flows into the N-type semiconductor material and flows through the metal substrate to the P-type semiconductor material, the heat energy generated by the active area is absorbed by the metal substrate through the thermal inner trench, and dissipated by opposite ends of the P-type semiconductor material and the N-type semiconductor material opposite to the metal substrate.

11. The power semiconductor structure of claim 10, wherein the gallium oxide substrate is a β-gallium oxide (β-Ga₂O₃) substrate.

## Amended claims

### Amended claims in accordance with Rule 137(2) EPC.

1. A power semiconductor structure, comprising:
a gallium-containing oxide substrate (10);
a gallium-containing oxide semiconductor layer, disposed on the gallium-containing oxide substrate (10);
a thermal inner trench (12), surrounding the gallium-containing oxide semiconductor layer and disposed on the gallium-containing oxide substrate (10);
a metal substrate (13), thermally connected to the thermal inner trench (12);
at least one pair of a P-type semiconductor material (15) and an N-type semiconductor material (14) respectively connected to two ends of the metal substrate (13); and
a thermal external trench (16) thermally connected to opposite ends of the P-type semiconductor material (15) and the N-type semiconductor material (14) relative to the metal substrate (13), wherein the thermal inner trench (12) and the thermal external trench (16) comprise a thermally conductive filler therein, wherein
the power semiconductor structure is configured such that, in operation, when an external current flows into the N-type semiconductor material (14) and flows through the metal substrate (13) to the P-type semiconductor material (15), whereby the heat energy generated by the gallium-containing oxide semiconductor layer is absorbed by the metal substrate (13) through the thermal inner trench (12), and dissipated to the thermal external trench (16) by the opposite ends of the P-type semiconductor material (15) and the N-type semiconductor material (14) opposite to the metal substrate (13).

2. The power semiconductor structure of the previous claim, wherein the gallium-containing oxide substrate (10) is a gallium oxide (Ga₂O₃) substrate.

3. The power semiconductor structure of the previous claim, wherein the gallium oxide (Ga₂O₃) substrate is a β-gallium oxide (β-Ga₂O₃) substrate.

4. The power semiconductor structure of any of the previous claims, wherein the gallium-containing oxide semiconductor layer is a gallium oxide (Ga₂O₃) semiconductor layer.

5. The power semiconductor structure of any of the previous claims , wherein the thermally conductive filler is selected from one of the groups consisting of diamond, aluminum nitride, and silicon dioxide, and a combination thereof.

6. The power semiconductor structure of any of the previous claims, wherein the at least one pair of the P-type semiconductor material (15) and the N-type semiconductor material (14) has a plurality of pairs of the P-type semiconductor material (15) and the N-type semiconductor material (14), respectively connected to two ends of the metal substrate (13) and arranged to be disposed on at least one side of the thermal inner trench (12).

7. The power semiconductor structure of any of the previous claims, wherein the at least one pair of the P-type semiconductor material (15) and the N-type semiconductor material (14) has a plurality of pairs of the P-type semiconductor material (15) and the N-type semiconductor material (14), respectively connected to two ends of the metal substrate (13) and surrounding the periphery of the thermal inner trench (12).

8. The power semiconductor structure of any of the previous claims, further comprising a thermal ring (17) surrounding the periphery of the thermal external trench (16) and thermally connected to the thermal external trench (16).
